(19) Europäisches Patentamt / European Patent Office / Office européen des brevets

(11) **EP 3 179 279 B1**

(12) **FASCICULE DE BREVET EUROPEEN**

(45) Date de publication et mention de la délivrance du brevet:
**07.06.2023 Bulletin 2023/23**

(21) Numéro de dépôt: **16306493.4**

(22) Date de dépôt: **15.11.2016**

(51) Classification Internationale des Brevets (IPC):
**G01V 99/00** (2009.01)    **E21B 41/00** (2006.01)

(52) Classification Coopérative des Brevets (CPC):
**G01V 99/00**

(54) **PROCEDE D'EXPLOITATION D'UN BASSIN SEDIMENTAIRE AU MOYEN DE CARTES DE TENEUR EN CARBONE ORGANIQUE ET D'INDICE D'HYDROGENE**

VERFAHREN ZUR AUSBEUTUNG EINES SEDIMENTBECKENS MITHILFE VON KARTEN MIT EINEM GEHALT AN ORGANISCH GEBUNDENEM KOHLENSTOFF, UND WASSERSTOFFINDEX

METHOD FOR EXPLOITING A SEDIMENTARY BASIN USING MAPS OF ORGANIC CARBON CONTENT AND HYDROGEN INDEX

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **10.12.2015 FR 1562115**

(43) Date de publication de la demande:
**14.06.2017 Bulletin 2017/24**

(73) Titulaire: **IFP Energies nouvelles**
**92500 Rueil-Malmaison (FR)**

(72) Inventeurs:
• DUCROS, Mathieu
  **92500 RUEIL-MALMAISON (FR)**
• CHAUVEAU, Benoit
  **75013 PARIS (FR)**

(74) Mandataire: **IFP Energies nouvelles**
**Département Propriété Industrielle**
**Rond Point de l'échangeur de Solaize**
**BP3**
**69360 Solaize (FR)**

(56) Documents cités:
EP-A1- 2 743 738    US-A1- 2015 081 265

• Celestine Eze: "Modelling organic carbon distribution influenced by the presence of an oxygen minimum zone", , 1 juin 2013 (2013-06-01), XP055295725, Extrait de l'Internet: URL:http://www.diva-portal.org/smash/get/d iva2:657465/FULLTEXT01.pdf [extrait le 2016-08-16]
• ANE LOTHE: "Exploration Technologies at SINTEF Petroleum Research", JOINING FORCES SEMINAR, 22 mai 2013 (2013-05-22), XP055295635,
• Eduardo Martinez: "Shale Gas Evaluation -Exploration", , 27 novembre 2012 (2012-11-27), XP055249896, Extrait de l'Internet: URL:http://www.geosoc.fr/numero-actuel/doc _download/135-shale-gas-evaluation-explora tion.html [extrait le 2016-02-15]
• MEHDI KHOSHNOODKIA ET AL: "TOC determination of Gadvan Formation in South Pars Gas field, using artificial intelligent systems and geochemical data", JOURNAL OF PETROLEUM SCIENCE AND ENGINEERING, ELSEVIER, AMSTERDAM, NL, vol. 78, no. 1, 1 mai 2011 (2011-05-01), pages 119-130, XP028280146, ISSN: 0920-4105, DOI: 10.1016/J.PETROL.2011.05.010 [extrait le 2011-05-11]
• Pathirana I. ET AL: "Towards an improved organic carbon budget for the western Barents Sea shelf", Climate of the Past, vol. 10, no. 2, 21 March 2014 (2014-03-21) , pages 569-587, XP055935070, DOI: 10.5194/cp-10-569-2014

## Description

La présente invention concerne le domaine de l'exploration pétrolière. L'exploration pétrolière consiste à rechercher des gisements d'hydrocarbures dans un bassin sédimentaire.

La démarche générale comporte des aller-retour entre :

- des expertises et des études géologiques d'évaluation du potentiel pétrolier du bassin sédimentaire, réalisées à partir des données disponibles (affleurements, campagnes sismiques, forages). Cette expertise vise :

  ◦ à mieux comprendre l'architecture et l'histoire géologique du sous-sol, notamment à étudier si des processus de maturation et de migration d'hydrocarbures ont pu se mettre en place ;

  ◦ à identifier les zones du sous-sol dans lesquelles ces hydrocarbures ont pu s'accumuler ;

  ◦ à établir quelles zones présentent le meilleur potentiel économique, évalué à partir du volume et de la nature des hydrocarbures probablement piégés (viscosité, taux de mélange avec de l'eau, composition chimique ...), ainsi que de leur coût d'exploitation (contrôlé par exemple par la profondeur et la pression de fluide).

- des forages d'exploration dans les différentes zones présentant le meilleur potentiel, afin de confirmer ou infirmer le potentiel estimé préalablement, et d'acquérir de nouvelles données pour alimenter de nouvelles études plus précises.

Dans certains bassins sédimentaires, ayant subi une histoire géologique compliquée faisant interagir de nombreux processus physiques, ou lorsque le volume de données est très important, une simple intervention humaine d'expertise ne suffit pas à prédire l'emplacement et l'intérêt économique des gisements. On met alors en oeuvre une démarche faisant appel à des outils informatiques de synthèse des données disponibles et de simulation de l'histoire géologique et des multiples processus physiques qui la contrôlent. Il s'agit d'une démarche dite de *"modélisation de bassin".* Elle fournit une cartographie prédictive du sous-sol indiquant l'emplacement probable des gisements, ainsi que la teneur, la nature et la pression des hydrocarbures qui y sont piégés.

La compréhension des principes de la genèse des hydrocarbures et de leurs liens avec l'histoire géologique du sous-sol a permis la mise au point de méthodes de prédiction du potentiel pétrolier et de l'emplacement des gisements dans les bassins sédimentaires. Ces méthodes s'appuyaient sur des observations géologiques effectuées sur le terrain, et des géologues experts intégraient leurs connaissances dans un raisonnement visant à fournir des hypothèses de scénarios de formation, migration et piégeage des hydrocarbures pour chaque bassin étudié. Les forages d'exploration étaient ensuite réalisés suivant leurs recommandations, avec un taux de succès de l'ordre d'une découverte de gisement pour 10 puits forés. Les informations fournies par cette phase d'expertise étaient essentiellement qualitatives.

Dans les années 80, le développement de l'informatique a fourni de nouveaux outils pour assister les géologues dans cette démarche, les aider à fournir des informations quantitatives et plus fiables, et leur permettre ainsi d'augmenter ce taux de succès. De nombreux codes informatiques ont été développés pour mieux appréhender et quantifier chacun des phénomènes géologiques contrôlant la formation, la migration et le piégeage des hydrocarbures. Parmi ces outils, on peut citer les logiciels dits "de modélisation (ou de simulation) de bassin".

*La modélisation de bassin*

Les logiciels de modélisation de bassin permettent de simuler en une, deux ou trois dimensions, l'ensemble des processus sédimentaires, tectoniques, thermiques, hydrodynamiques et de chimie organique et inorganique qui interviennent lors de la formation d'un bassin pétrolier. Ces logiciels constituent un outil fondamental pour l'exploration pétrolière, car ils fournissent en sortie l'ensemble des données nécessaires à la prédiction de la localisation des gisements et de leur intérêt économique. Les documents EP 2 743 738 A1, A. Lothe, "Exploration Technologies at SINTEF Petroleum Research", JOINING FORCES SEMINAR, 22 mai 2013, et US 2015/081265 A1 décrivent des exemples de procédé d'exploitation d'un bassin sédimentaire au moyen d'un simulation.

La démarche suivie par la plupart des modèles de bassin comporte trois phases :

1. une phase de construction d'un maillage du sous-sol suivant une hypothèse sur son architecture interne et sur les propriétés qui caractérisent chaque maille : par exemple leur porosité, leur nature sédimentaire (argile, sable ...) ou encore leur teneur en matière organique au moment de leur sédimentation. La construction de ce modèle se base sur des données acquises par campagnes sismiques ou mesures lors du forage. Ce maillage est structuré en couches : un groupe de mailles est affecté à chaque couche géologique du bassin modélisé.

2. une phase de reconstruction du maillage représentant des états antérieurs de l'architecture du bassin. Cette étape est réalisée à l'aide, par exemple, d'une méthode de "backstripping" (Steckler, M.S., and A.B. Watts, Subsidence of the Atlantic-type continental margin off New York, Earth Planet. Sci. Lett., 41, 1-13, 1978.) ou une méthode de restauration structurale (décrit par exemple dans la demande de brevet FR 2930350 - US 8150669).

3. une étape de simulation numérique d'une sélection de phénomènes physiques se déroulant au cours de l'évolution du bassin et contribuant à la formation des pièges pétroliers. Cette étape s'appuie sur une représentation discrétisée du temps en « évènements », chaque évènement étant simulé par une succession de pas de temps. Le début et la fin d'un évènement correspondent à deux états successifs de l'évolution de l'architecture du bassin fournis à l'étape 2 précédente.

Genèse des hydrocarbures

Parmi les phénomènes physiques pris en compte dans l'étape 3 ci-dessus, on simule notamment la transformation en hydrocarbures de la matière organique initialement enfouie avec les sédiments, et le cheminement de ces hydrocarbures depuis les roches, dans lesquelles ils se sont formés jusqu'à celles où ils sont piégés.

Les procédés de modélisation de bassin proposés actuellement permettent de simuler trois processus possibles de formation d'hydrocarbures :

- par action directe de certains micro-organismes présents en profondeur dans les sédiments qui dégradent la matière organique initiale en produisant notamment du méthane ; il s'agit de la production biogénique primaire (décrit par exemple dans la demande de brevet WO 2014/040622 A1).

- par transformation chimique et/ou thermodynamique de la matière organique sous l'effet des fortes températures qui règnent dans le sous-sol profond (décrit par exemple dans la demande de brevet WO 2014/040622 A1).

- par action de certains micro-organismes du sous-sol profond qui dégradent certains hydrocarbures en produisant notamment du méthane : il s'agit de la production biogénique à partir d'hydrocarbures fluides (décrit par exemple dans la demande de brevet FR 2888251 - US 8753867)

Migration des hydrocarbures

Ces mêmes logiciels permettent également de simuler le transport des hydrocarbures produits, notamment le méthane biogénique primaire et secondaire, en faisant l'hypothèse que ceux-ci se déplacent sous la forme d'une ou plusieurs phases, séparées de la phase aqueuse, que l'on nommera « phases hydrocarbures » ou « gaz libre ». Plusieurs méthodes sont disponibles pour modéliser la migration des phases hydrocarbures : la méthode par lancer de rayon (Sylta, Modeling techniques for hydrocarbon migration, In EAGE 64th Conférence and Exhibition, Florence, 2002), la méthode par invasion percolation (Carruthers, Transport of secondary oil migration using gradient-driven invasion percolation techniques. PhD thesis, Heriot-Watt University, Edinburgh, Scotland, UK, 1998), et la résolution des équations de Darcy généralisées (Schneider, Modelling multi-phase flow of petroleum at the sedimentary basin scale. Journal of Geochemical exploration 78-79 (2003) 693-696).

Les hydrocarbures piégés dans les réservoirs pétroliers sont majoritairement issus de la transformation en hydrocarbures de la matière organique solide et ce principalement sous l'effet de la chaleur. Cette dernière est souvent caractérisée par sa teneur en carbone organique (TOC) et son indice d'hydrogène (IH) qui permettent de connaître le potentiel pétrolier de la roche mère (i.e. sa capacité à produire des hydrocarbures, sa richesse). Les valeurs de IH et de TOC sont classiquement évaluées à l'état actuel (i.e. après possible altération thermique subie dans les conditions géologiques), grâce à des outils tels que le Rock-Eval ® (IFP Energies nouvelles, France).

Les modèles de bassin ont parmi leurs objectifs, l'estimation des quantités d'hydrocarbures générés par les roches-mères et piégés dans les réservoirs pétroliers. Ces quantités dépendent ainsi directement de la distribution spatiale de la matière organique et de sa richesse. Il est toutefois très difficile d'avoir une représentation juste de ces paramètres, car les roches-mères (qui contiennent la matière organique) ne sont connues que lorsqu'elles affleurent (elles peuvent alors être relativement bien caractérisées, mais leur caractérisation revêt une importance moindre, car il est alors peu probable qu'elles aient généré des hydrocarbures, ou que ces derniers soient encore exploitables), ou lorsque des puits de forage pétrolier ont pu l'atteindre. Pour des réservoirs dits « conventionnels », les forages pétroliers ne vont malheureusement que très peu souvent jusqu'à la roche-mère, ce qui rend l'estimation de la distribution de la richesse de la matière organique difficile. Même dans le cas des réservoirs dits « non-conventionnels », pour lequel le réservoir est généralement la roche-mère elle-même, il reste difficile de l'estimer correctement, la densité des puits n'étant pas toujours suffisante pour avoir une image globale de la distribution de la matière organique.

En modélisation de bassin, les données concernant la richesse de la matière organique sont indispensables à la simulation de la génération et de la migration des hydrocarbures, les utilisateurs sont donc obligés de construire des cartes de TOC et de IH à partir des quelques données en leur possession. Les cartes sont alors souvent uniformes (même valeur sur l'ensemble de la carte) ou obtenues par interpolation / extrapolation mathématique (méthodes de krigeage, de « smoothing »...) à partir de quelques points. Les processus responsables du dépôt de la matière organique ne sont ainsi pas pris en compte dans l'estimation des cartes de richesse.

Une autre solution tenant compte des processus liés au dépôt de la matière organique consiste à utiliser des outils de modélisation des dépôts sédimentaires tels que DionisosFlow ® (IFP Energies nouvelles). Ces outils demandent toutefois de gros investissements en temps car ils requièrent de nombreuses données additionnelles, des simulations supplémentaires et des compétences que n'ont pas nécessairement les utilisateurs de modélisation de bassin.

Pour pallier ces inconvénients, la présente invention concerne un procédé d'exploitation d'un bassin sédimentaire. L'exploitation du bassin sédimentaire est permise par le choix de zones d'intérêt au sein du bassin, les zones étant déterminées au moyen de cartes de teneur en carbone organique TOC et d'indice d'hydrogène IH d'au moins une couche sédimentaire. Selon l'invention, les cartes de teneur en carbone organique TOC et d'indice d'hydrogène IH sont obtenues en prenant en compte des valeurs actuelles de TOC et IH au niveau du puits et en prenant en compte les cartes de bathymétrie et de vitesse de sédimentation. Ainsi, le procédé selon l'invention permet de déterminer des cartes de richesse TOC et IH avant que ces propriétés ne soient affectés par les processus thermiques sur la base des informations dont dispose le modélisateur de bassin (généralement TOC et IH en quelques puits, généralement affectés par les processus thermiques) et des processus physiques et chimiques (cartes de sédimentation et de bathymétrie) sans avoir recours à des simulations de dépôt sédimentaire, qui nécessiteraient plus de temps, de données et de compétences.

**Le procédé selon l'invention**

L'invention concerne un procédé d'exploitation d'un bassin sédimentaire mis en oeuvre par ordinateur selon la revendication 1.

Avantageusement, on cale lesdits modèles en mettant en oeuvre les étapes suivantes :

(1) on choisit des paramètres biologiques et chimiques de ladite couche sédimentaire ;
(2) on détermine des valeurs de teneur en carbone organique $TOC_{0S}(P)$ et d'indice d'hydrogène $IH_{0S}(P)$ au niveau dudit puits au temps du dépôt de ladite couche sédimentaire au moyen desdits modèles, desdits paramètres biologiques et chimiques choisis et desdites cartes de bathymétrie et de vitesse de sédimentation ;
(3) on calcule une valeur de teneur en carbone organique $TOC_{0BC}(P)$ au niveau dudit puits au temps du dépôt de ladite couche sédimentaire au moyen d'un bilan carbone et desdites valeurs de teneur en carbone organique $TOC_A(P)$ et la valeur de l'indice d'hydrogène $IH_A(P)$ au temps actuel au niveau dudit puits ;
(4) on compare lesdites valeurs déterminées $TOC_{0S}(P)$ et calculées $TOC_{0BC}(P)$ de teneur en carbone organique au niveau dudit puits au temps de dépôt de ladite couche sédimentaire, et on réitère les étapes (2) à (4) en modifiant lesdits paramètres biologiques et chimiques pour minimiser ladite comparaison.

Selon une variante de réalisation, on calcule la valeur de teneur en carbone organique $TOC_{0BC}(P)$ au niveau dudit puits au temps du dépôt de ladite couche sédimentaire au moyen d'une formule du type :

$$TOC_{0BC}(P) = \frac{TOC_A(P)}{1 - \frac{IH_{0S}(P) - IH_A(P)}{1000} \times 0.84}.$$

Alternativement, on calcule la valeur de teneur en carbone organique $TOC_{0BC}(P)$ au niveau dudit puits au temps du dépôt de ladite couche sédimentaire au moyen d'une formule du type :

$$TOC_{0BC}(P) = \frac{TOC_A(P) - 0.84 \times S1}{1 - \frac{IH_{0S}(P) - IH_A(P)}{1000} \times 0.84}$$ avec S1 la quantité d'huiles libres.

De préférence, ladite valeur de teneur en carbone organique $TOC_{0BC}(P)$ au niveau dudit puits au temps du dépôt de ladite couche sédimentaire est fonction d'un paramètre relatif à la formation de gaz biogénique au sein de ladite couche sédimentaire.

Selon une mise en oeuvre de l'invention, lesdits paramètres biologiques et chimiques sont des paramètres représentatifs du dépôt de matière organique et/ou des réactions de réduction et/ou d'oxydation.

Conformément à un mode de réalisation de l'invention, lesdits modèles sont formés par interpolation desdites valeurs de teneur en carbone organique $TOC_0(P)$ et d'indice d'hydrogène $IH_0(P)$ au niveau dudit puits au temps du dépôt de ladite couche sédimentaire, l'interpolation étant contrainte par lesdites cartes de vitesse de sédimentation et de bathymétrie.

De manière avantageuse, lesdites valeurs de teneur en carbone organique $TOC_A(P)$ et de l'indice d'hydrogène $IH_A(P)$ au temps actuel au niveau dudit puits sont déterminées par analyse d'une pyrolyse d'une roche de ladite couche sédimentaire.

Conformément à un mode de réalisation de l'invention, on détermine au moins une zone dudit bassin sédimentaire comportant des hydrocarbures au moyen d'un modèle dudit bassin sédimentaire construit au moyen desdites cartes de teneur en carbone organique $TOC_0$ et d'indice d'hydrogène $IH_0$ au temps du dépôt de ladite couche sédimentaire.

En outre, l'invention concerne un produit programme d'ordinateur téléchargeable depuis un réseau de communication et/ou enregistré sur un support lisible par ordinateur et/ou exécutable par un processeur, comprenant des instructions de code de programme pour la mise en oeuvre du procédé selon l'une des caractéristiques précédentes, lorsque ledit programme est exécuté sur un ordinateur.

## Présentation succincte des figures

D'autres caractéristiques et avantages du procédé selon l'invention, apparaîtront à la lecture de la description ci-après d'exemples non limitatifs de réalisations, en se référant aux figures annexées et décrites ci-après.

La figure 1 illustre les étapes du procédé d'exploitation selon un mode de réalisation de l'invention.
La figure 2 illustre les étapes du calage du modèle selon un mode de réalisation de l'invention.
La figure 3 illustre une carte de bathymétrie pour un exemple.
La figure 4 illustre une carte de vitesse de sédimentation pour l'exemple de la figure 3.
La figure 5 illustre une carte de teneur en carbone organique $TOC_0$ au niveau de la couche sédimentaire pour l'exemple de la figure 3, la carte étant obtenue par le procédé selon l'invention.
La figure 6 illustre une carte d'indice d'hydrogène $IH_0$ au niveau de la couche sédimentaire pour l'exemple de la figure 3, la carte étant obtenue par le procédé selon l'invention.

## Description détaillée de l'invention

La présente invention concerne un procédé d'exploitation d'un bassin sédimentaire. Le bassin sédimentaire comprend au moins une couche sédimentaire, et est traversé par au moins un puits, par exemple un puits d'exploration, un puits injecteur ou un puits producteur.

Notations :

Au cours de la description, les notations suivantes seront utilisées :

TOC : teneur en carbone, avec :

- $TOC_A$ : valeur actuelle de la teneur en carbone,
- $TOC_0$ : valeur de teneur en carbone lors du dépôt de la couche sédimentaire,
- $TOC_{0S}$ : valeur de teneur en carbone simulée obtenue par le modèle selon l'invention, la valeur étant celle lors du dépôt de la couche sédimentaire,
- $TOC_{0BC}$ : valeur de teneur en carbone calculée obtenue par un bilan carbone, la valeur étant celle lors du dépôt de la couche sédimentaire,

IH : indice d'hydrogène, avec :

- $IH_A$ : valeur actuelle de l'indice d'hydrogène,
- $IH_0$ : valeur de l'indice d'hydrogène lors du dépôt de la couche sédimentaire,
- $IH_{0S}$ : valeur de l'indice d'hydrogène simulée obtenue par le modèle selon l'invention, la valeur étant celle lors du dépôt de la couche sédimentaire.

Ces notations, lorsqu'elles sont suivies de la notation (P), désignent les valeurs au niveau d'un puits. Lorsqu'elles ne sont pas suivies de la notation (P), désignent les valeurs en tout point de la couche sédimentaire.

On appelle valeur actuelle ou valeur au temps actuelle, la valeur obtenue par mesure à l'instant présent (au pas de temps actuel), auquel on met en oeuvre le procédé selon l'invention, la roche peut avoir subie des altérations thermiques dans les conditions géologiques. A contrario, la valeur lors du dépôt ou au temps du dépôt de la couche sédimentaire, correspond à la valeur au temps géologique (c'est-à-dire au pas de temps géologique), pour lequel la couche sédimentaire s'est formée.

Le procédé d'exploitation selon l'invention utilise les informations suivantes :

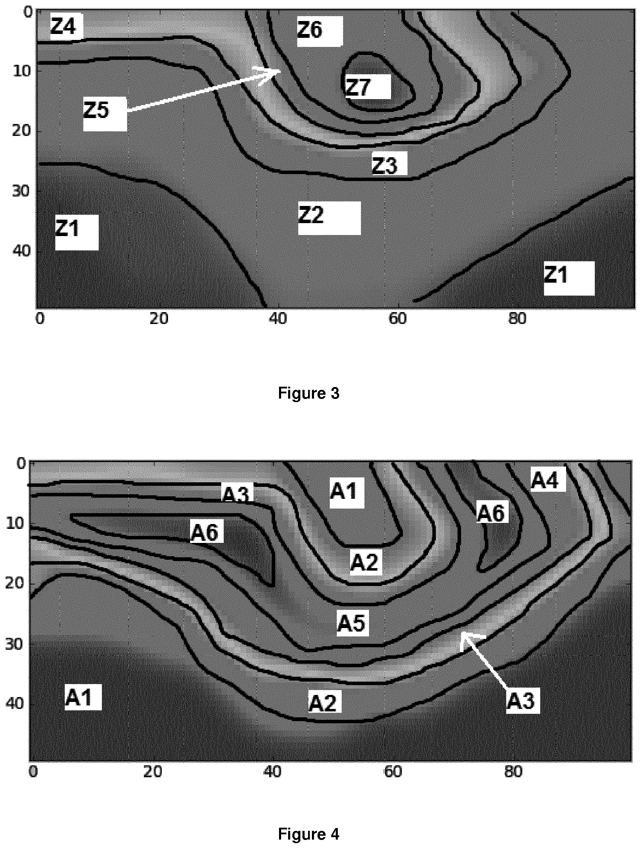

- $TOC_A(P)$ : valeur actuelle de la teneur en carbone au niveau d'au moins un puits, cette valeur peut être obtenue grâce à des outils d'analyse de roche prélevée dans le bassin sédimentaire, tel que le Rock-Eval ® (IFP Energies nouvelles, France) ou tout outil analogue,
- $IH_A(P)$ : valeur actuelle de l'indice d'hydrogène au niveau d'au moins un puits, cette valeur peut être obtenue grâce à des outils d'analyse de roche prélevée dans le bassin sédimentaire, tel que le Rock-Eval ® (IFP Energies nouvelles, France) ou tout outil analogue,
- une carte de bathymétrie de la couche sédimentaire, qui est une carte qui indique la profondeur des mailles de la carte par rapport au niveau de la mer, cette carte est généralement utilisée lors de la construction de modèle de bassin, la figure 3, qui sera détaillée dans la suite de la description, est un exemple de carte de bathymétrie, et
- une carte de vitesse de sédimentation, qui est une carte qui est représentative de la durée du dépôt et de l'épaisseur de l'évènement, cette carte est généralement utilisée lors de la construction de modèle de bassin, la figure 4, qui sera détaillée dans la suite de la description, est un exemple de carte de vitesse de sédimentation.

On appelle carte, une représentation maillée de la couche sédimentaire, elle représente une maquette de la couche sédimentaire. A chaque maille est associée une propriété de la maille. Par exemple, la propriété peut être la bathymétrie, la vitesse de sédimentation, la teneur en carbone organique, l'indice d'hydrogène, etc. Classiquement, la carte peut être une représentation numérique, réalisée sur ordinateur.

On rappelle que le Rock-Eval ® (IFP Energies nouvelles, France) est un système mettant en oeuvre une pyrolyse d'une roche issue du sous-sol. Elle fournit, en effet, et d'une façon rapide, différentes informations sur le contenu organique des roches, telles que le potentiel pétrolier des séries rencontrées, la nature des kérogènes, leur état de maturation. Le système est la méthode sont notamment décrits dans la demande de brevet FR 2722296 (US 5843787). Par exemple, le Rock-Eval ® (IFP Energies nouvelles, France) peut délivrer des paramètres classiques tels que :

- la quantité de gaz libres: sa ;
- la quantité d'huiles libres: S1' ;
- le potentiel pétrolier, ou hydrocarbures issus de pyrolyse: S2 ;
- la température du sommet du pic S2: TMax ;
- le carbone organique total, TOC ; et
- l'index d'hydrogène IH

Le procédé selon l'invention comprend les étapes suivantes :

1) construction des cartes de TOC et d'IH pour au moins une couche sédimentaire,
2) détermination d'une zone d'intérêt, et
3) exploitation du bassin sédimentaire.

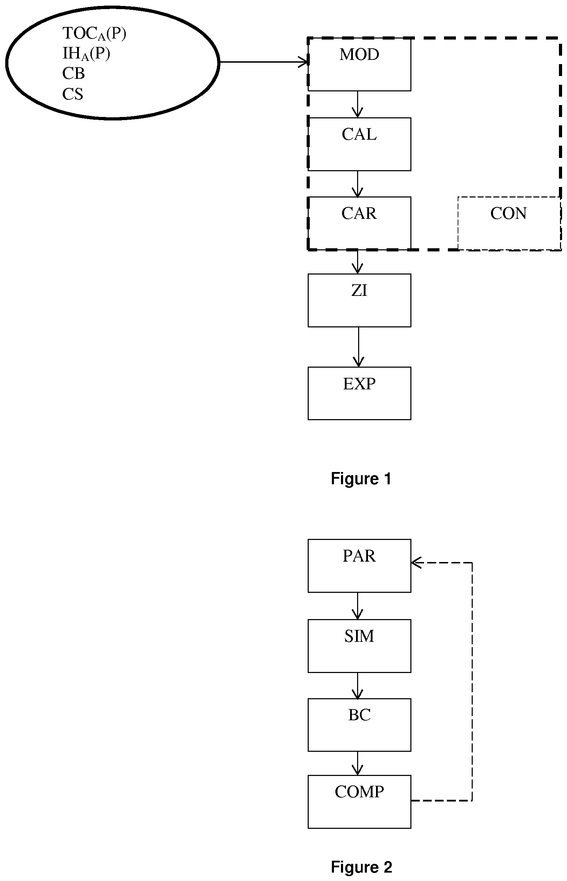

La figure 1 illustre de manière schématique et non limitative les étapes du procédé selon un mode de réalisation de l'invention. Pour le procédé illustré, les informations suivantes sont connues : la valeur actuelle de la teneur en carbone au niveau d'un puits $TOC_A(P)$, valeur actuelle de l'indice d'hydrogène au niveau d'un puits $IH_A(P)$, la carte de bathymétrie CB et la carte de vitesse de sédimentation CS. Une première étape consiste en une étape de construction CON des cartes de teneur en carbone organique TOC et d'indice hydrogène IH pour au moins une couche sédimentaire. Selon un mode de réalisation de l'invention, détaillé dans la suite de la description, l'étape de construction CON peut comprendre une étape de modélisation MOD, une étape de calage des modèles CAL, et une étape d'application des modèles pour former les cartes CAR. Après l'étape de construction CON, le procédé selon l'invention peut comprendre une étape détermination d'au moins une zone d'intérêt ZI, en fonction des cartes de TOC et d'IH construites, par exemple au moyen d'une modélisation de réservoir. Enfin, le procédé selon l'invention comprend une étape d'exploitation du bassin sédimentaire EXP en fonction de la zone d'intérêt déterminée ZI.

Etape 1) Construction des cartes de TOC d'IH

Lors de cette étape, on construit les cartes de teneur en carbone organique TOC, et d'indice d'hydrogène IH pour au moins une couche sédimentaire du bassin sédimentaire. Les valeurs de TOC et IH des cartes étant celles déterminées au temps du dépôt de la couche sédimentaire. De préférence, on construit les cartes de TOC et d'IH pour chaque couche sédimentaire du bassin sédimentaire pouvant comprendre des hydrocarbures. Cette étape 1) est alors répétée pour chaque couche du bassin sédimentaire à étudier.

Cette étape peut être réalisée numériquement.

Selon une mise en oeuvre de cette étape, on peut construire les cartes de TOC et d'IH en mettant en oeuvre les étapes suivantes :

i) on construit des modèles de teneur en carbone organique $TOC_0$ et d'indice d'hydrogène $IH_0$ en tout point de la couche sédimentaire au temps du dépôt de la couche sédimentaire, les modèles reliant la teneur en carbone organique $TOC_0$ et l'indice d'hydrogène $IH_0$ en tout point de ladite couche sédimentaire au temps du dépôt de ladite couche sédimentaire, avec les cartes de bathymétrie et de vitesse de sédimentation de la couche sédimentaire, et avec des paramètres chimiques et biologiques de la couche sédimentaire ;

ii) on cale les modèles en déterminant les paramètres chimiques et biologiques au moyen des valeurs actuelles de teneur en carbone organique $TOC_A(P)$ et la valeur de l'indice d'hydrogène $IH_A(P)$ au niveau du puits ; et

iii) on construit les cartes de teneur en carbone organique $TOC_0$ et d'indice d'hydrogène $IH_0$ au temps du dépôt de la couche sédimentaire en appliquant les modèles calés en tout point du bassin sédimentaire au moyen des paramètres chimiques et biologiques déterminés et des cartes de vitesse de sédimentation et de bathymétrie.

Les paramètres biologiques et chimiques des modèles de TOC et d'IH peuvent être des paramètres représentatifs du dépôt de matière organique et/ou des réactions de réduction et/ou d'oxydation de la matière organique.

Les modèles prennent donc en compte des données relatives à la bathymétrie et à la vitesse de sédimentation, qui sont variables au sein de la couche sédimentaire. Par conséquent, les modèles peuvent donc être représentatifs de la couche sédimentaire, en prenant en compte ces phénomènes géologiques. De plus, les modèles prennent en compte les conditions biologiques et chimiques, ce qui permet de rendre ces modèles cohérents avec les phénomènes biologiques et chimiques au sein de la couche sédimentaire.

Ainsi, le modèle de teneur en carbone organique $TOC_0$ en tout point de la couche sédimentaire au temps du dépôt de la couche sédimentaire peut s'écrire sous la forme d'une fonction f :

$$TOC_0 = f(CB, CS, PB, PC)$$

avec CB la carte de bathymétrie (connue), CS la carte de vitesse de sédimentation (connue), PB les paramètres biologiques (à caler) et PC les paramètres chimiques (à caler).

De la même manière, le modèle d'indice d'hydrogène $IH_0$ en tout point de la couche sédimentaire au temps du dépôt de la couche sédimentaire peut s'écrire sous la forme d'une fonction g :

$$IH_0 = g(CB, CS, PB, PC)$$

avec CB la carte de bathymétrie (connue), CS la carte de vitesse de sédimentation (connue), PB les paramètres biologiques (à caler) et PC les paramètres chimiques (à caler).

Le but de calage est de déterminer les paramètres biologiques et chimiques qui permettent de rendre cohérent le modèle avec les valeurs connues au niveau du puits. Le calage des modèles est réalisé au moyen des valeurs actuelles de teneur en carbone organique $TOC_A(P)$ et la valeur de l'indice d'hydrogène $IH_A(P)$ au niveau du puits. Ainsi, les modèles sont calés avec des données mesurées et permettent une cohérence entre les modèles et les données réelles.

Selon un mode de réalisation, pour lequel des valeurs actuelles de teneur en carbone organique $TOC_A(P)$ et de l'indice d'hydrogène $IH_A(P)$ sont connues au niveau de plusieurs puits, le calage peut être mis en oeuvre pour déterminer les paramètres biologiques et chimiques qui permettent de rendre cohérents le modèle avec les valeurs actuelles pour tous les puits.

La figure 2 illustre de manière schématique et non limitative, les étapes du calage du modèle. Dans un premier temps, on choisit des paramètres biologiques et chimiques PAR. Ces paramètres PAR sont utilisés pour simuler SIM, c'est-à-dire pour déterminer à l'aide des modèles, des valeurs de TOC et d'IH au niveau du puits lors du dépôt de la couche sédimentaire. Ensuite, on calcule au moyen d'un bilan carbone BC, une valeur de TOC au niveau du puits lors du dépôt de la couche sédimentaire. Enfin, la valeur de TOC simulée et la valeur de TOC calculée sont comparées COMP. Si la différence entre la valeur simulée et la valeur calculée n'est pas minimale, alors les étapes précédentes sont répétées (flèche en pointillés) en modifiant les paramètres biologiques et chimiques. Dans le cas inverse, on conserve les paramètres biologiques et chimiques qui minimisent la différence entre la valeur simulée et la valeur calculée. Dans le cas de plusieurs puits, la sélection des paramètres biologiques et chimiques optimaux sont déduits en minimisant la somme des écarts, selon une méthode classique (par exemple les moindres carrés).

Selon une mise en oeuvre préférée de l'invention, on peut réaliser le calage en mettant en oeuvre les étapes suivantes :

(1) on choisit des paramètres biologiques et chimiques de la couche sédimentaire ;
(2) on détermine des valeurs de teneur en carbone organique $TOC_{0S}(P)$ et d'indice d'hydrogène $IH_{0S}(P)$ au niveau du puits au temps du dépôt de la couche sédimentaire au moyen des modèles, des paramètres biologiques et chimiques choisis à l'étape précédente ou modifiés pour la nouvelle itération, et des cartes de bathymétrie et de vitesse de sédimentation ;
(3) on calcule une valeur de teneur en carbone organique $TOC_{0BC}(P)$ au niveau dudit puits au temps du dépôt de ladite couche sédimentaire au moyen d'un bilan carbone et des valeurs de teneur en carbone organique $TOC_A(P)$ et la valeur de l'indice d'hydrogène $IH_A(P)$ au temps actuel au niveau du puits ;
(4) on compare les valeurs déterminées $TOC_{0S}(P)$ et calculées $TOC_{0BC}(P)$ de teneur en carbone organique au niveau dudit puits au temps de dépôt de la couche sédimentaire, et on réitère les étapes (2) à (4) en modifiant lesdits paramètres biologiques et chimiques pour minimiser la comparaison. Par exemple, si la comparaison est supérieure à un seuil, les paramètres biologiques et chimiques sont modifiés, et si la comparaison est inférieure à ce seuil, alors les paramètres biologiques et chimiques utilisés dans les modèles sont ceux qui permettent cette comparaison.

Pour la première itération, le choix des paramètres biologiques et chimiques peut être quelconque, ou dépendre de mesures. Pour les itérations suivantes, les paramètres biologiques et chimiques sont déterminés de manière à minimiser la différence entre la valeur simulée et la valeur calculée.

Pour l'étape de détermination des valeurs $TOC_{0S}(P)$ et $IH_{0S}(P)$, on applique les modèles, au niveau du puits, avec les paramètres choisis et les cartes de vitesse de sédimentation et de bathymétrie connues.

Pour l'étape de calcul de la valeur de $TOC_{0BC}(P)$, on applique un bilan carbone au niveau du puits. Selon une première alternative, on peut calculer la valeur de teneur en carbone organique $TOC_{0BC}(P)$ au niveau dudit puits au temps du dépôt de ladite couche sédimentaire au moyen d'une formule du type :

$$TOC_{0BC}(P) = \frac{TOC_A(P)}{1-\frac{IH_{0S}(P)-IH_A(P)}{1000}\times C}$$

, avec C une constante, correspondant au ratio en pourcent de carbone organique dans les hydrocarbures. Classiquement, la constante C peut valoir 0,84. Selon une deuxième alternative, on peut calculer la valeur de teneur en carbone organique $TOC_{0BC}(P)$ au niveau dudit puits au temps du dépôt

$$TOC_{0BC}(P) = \frac{TOC_A(P)-0.84\times S1}{1-\frac{IH_{0S}(P)-IH_A(P)}{1000}\times C}$$

de ladite couche sédimentaire au moyen d'une formule du type :

avec S1 la quantité d'huiles libres, cette quantité peut être mesurée à partir de l'outil Rock-Eval ® (IFP Energies nouvelles, France), et C une constante, correspondant au ratio en pourcent de carbone organique dans les hydrocarbures. Classiquement, la constante C peut valoir 0,84. Pour ces deux alternatives, le bilan carbone dépend de la valeur déterminée de l'indice d'hydrogène $IH_{0S}(P)$ et des données au niveau du puits. En outre, le bilan carbone utilisé pour le calcul de la valeur de $TOC_{0BC}(P)$ peut être fonction de la formation du gaz biogénique, de manière à être plus complet.

La comparaison de la valeur déterminée par les modèles et la valeur calculée peut consister en une comparaison mathématique des valeurs, le but est de minimiser l'écart entre la valeur déterminée par les modèles et la valeur déterminée par bilan carbone. Si ces valeurs ne sont pas cohérentes alors les étapes sont réitérées en optimisant les paramètres biologiques et chimiques. Pour le mode de réalisation, pour lequel plusieurs valeurs actuelles de teneur en carbone organique $TOC_A(P)$ et de l'indice d'hydrogène $IH_A(P)$ sont connues au niveau de plusieurs puits, la comparaison peut être fonction des comparaisons au niveau de chaque puits, par exemple au moyen d'une méthode des moindres carrés.

A la fin du calage, les modèles de valeur de teneur en carbone organique et d'indice d'hydrogène sont entièrement paramétrés. On peut donc construire les cartes de TOC et d'IH pour la couche sédimentaire en appliquant le modèle calé (avec les paramètres biologiques et chimiques calés et les cartes de bathymétrie et de vitesse de sédimentation connues) à toutes les mailles représentatives du bassin sédimentaire.

L'avantage du procédé selon l'invention est qu'il permet ensuite de déterminer les cartes de $TOC_0$ et de $IH_0$ à l'échelle du bassin sur la base des processus chimiques et biologiques. Le procédé selon l'invention ne fait aucune hypothèse a priori sur la valeur de l'indice d'hydrogène $IH_0$, qui est déterminée dans la procédure d'optimisation des paramètres chimiques et biologiques. Dans les approches classiques de l'art antérieur, une hypothèse sur le $IH_0$ est

nécessaire au calcul de la valeur de teneur en carbone organique $TOC_0$ à partir des équations tirées des bilan carbones. Par manque d'information, un $IH_0$ homogène spatialement dans le bassin est utilisé. Or, les conditions de vitesse de sédimentation et de bathymétrie variables dans le bassin sont connues et on peut voir qu'elles permettent d'aboutir à des variations spatiales de $IH_0$ (comme illustré dans la fig. 4) si elles sont prises en compte.

Etape 2) Détermination d'une zone d'intérêt

Au moyen des cartes de TOC et d'IH de la couche sédimentaire, on détermine au moins une zone d'intérêt du bassin sédimentaire, qui peut comporter des hydrocarbures. En effet, la teneur en carbone organique et en hydrogène sont des indices de zones dans lesquelles, des hydrocarbures ont pu se former et/ou s'accumuler.

De préférence, on met en oeuvre cette étape au moyen d'une modélisation de bassin, qui intègre les cartes de TOC et d'IH construites. Elle fournit une cartographie prédictive du sous-sol indiquant l'emplacement probable des gisements, ainsi que la teneur, la nature et la pression des hydrocarbures qui y sont piégés, en prenant en compte la genèse, la migration et éventuellement la dégradation des hydrocarbures. Le modèle de bassin s'appuie sur une discrétisation spatiale et temporelle du bassin, il représente une maquette du bassin sédimentaire. La discrétisation spatiale est organisée en couches de mailles représentant les couches géologiques. A chaque maille est associée au moins une propriété de la maille, par exemple la densité de roche, la porosité, la teneur en carbone organique TOC, l'indice d'hydrogène IH, etc. La discrétisation temporelle repose sur le découpage du temps en intervalles de temps élémentaires : les « pas de temps ». Une simulation complète est constituée d'un ensemble de séquences temporelles que l'on nomme « évènements », qui sont elles-mêmes subdivisées en pas de temps. Un évènement dure donc au moins un pas de temps, et correspond à la mise en place d'une couche géologique. Classiquement, le modèle de bassin peut être une représentation numérique, réalisée sur ordinateur.

Les logiciels de modélisation de bassin permettent de simuler en une, deux ou trois dimensions, l'ensemble des processus sédimentaires, tectoniques, thermiques, hydrodynamiques et de chimie organique et inorganique qui interviennent lors de la formation d'un bassin pétrolier. Ces logiciels constituent un outil fondamental pour l'exploration pétrolière, car ils fournissent en sortie l'ensemble des données utiles à la prédiction de la localisation des gisements et de leur intérêt économique.

La démarche suivie par la plupart des modèles de bassin comporte trois phases :

1. une phase de construction d'un maillage du sous-sol suivant une hypothèse sur son architecture interne et sur les propriétés qui caractérisent chaque maille : par exemple leur porosité, leur nature sédimentaire (argile, sable ...) ou encore leur teneur en matière organique au moment de leur sédimentation. La construction de ce modèle se base sur des données acquises par campagnes sismiques ou mesures en forages. Ce maillage est structuré en couches : un groupe de mailles est affecté à chaque couche géologique du bassin modélisé.

2. une phase de reconstruction du maillage représentant des états antérieurs de l'architecture du bassin. Cette étape est réalisée à l'aide, par exemple, d'une méthode de "backstripping" (Steckler, M.S., and A.B. Watts, Subsidence of the Atlantic-type continental margin off New York, Earth Planet. Sci. Lett., 41, 1-13, 1978.) ou une méthode de restauration structurale (décrit par exemple dans la demande de brevet FR 2930350 - US 8150669). Lors de cette phase, on intègre les cartes de TOC et d'IH construites pour la(es) couche(s) sédimentaire(s).

3. une étape de simulation numérique d'une sélection de phénomènes physiques se déroulant au cours de l'évolution du bassin et contribuant à la formation des pièges pétroliers. Cette étape s'appuie sur une représentation discrétisée du temps en « évènements », chaque évènement étant simulé par une succession de pas de temps. Le début et la fin d'un évènement correspondent à deux états successifs de l'évolution de l'architecture du bassin fournis à l'étape 2 précédente.

A partir la modélisation de bassin, le spécialiste peut déterminer au moins une zone du bassin, correspondant à des mailles de ladite représentation maillée au temps actuel dudit bassin, comportant des hydrocarbures, ainsi que la teneur, la nature et la pression des hydrocarbures qui y sont piégés. Le spécialiste est alors en mesure de sélectionner les zones du bassin étudié présentant le meilleur potentiel pétrolier.

Etape 3) Exploitation du bassin sédimentaire

Lors de cette étape, on exploite la zone d'intérêt déterminée du bassin sédimentaire.
L'exploitation pétrolière du bassin peut alors prendre plusieurs formes, notamment :

- la réalisation de forages d'exploration dans les différentes zones sélectionnées comme présentant le meilleur potentiel, afin de confirmer ou infirmer le potentiel estimé préalablement, et d'acquérir de nouvelles données pour alimenter de nouvelles études plus précises,

- la réalisation de forages d'exploitation (puits producteurs ou injecteurs) pour la récupération des hydrocarbures présents au sein du bassin sédimentaire dans les zones sélectionnées comme présentant le meilleur potentiel.

En outre, l'invention concerne un produit programme d'ordinateur téléchargeable depuis un réseau de communication et/ou enregistré sur un support lisible par ordinateur et/ou exécutable par un processeur, comprenant des instructions de code de programme pour la mise en oeuvre du procédé tel que décrit précédemment, lorsque ledit programme est exécuté sur un ordinateur.

Exemple illustratif

Le procédé selon l'invention est appliqué pour déterminer la richesse de la roche mère dans une couche sédimentaire du bassin Ouest Canadien.

Ce bassin fait actuellement l'objet d'une exploration pétrolière intense notamment dans les réservoirs « non-conventionnels » des formations Montney et Doig. La rentabilité des prospects non-conventionnels étant en partie liée à la richesse de la roche-mère (qui constitue également le réservoir des hydrocarbures), il est essentiel pour les producteurs pétroliers de correctement estimer la distribution du potentiel pétrolier dans le bassin avant de réaliser les modélisations de bassin.

Le procédé de détermination du TOC selon l'invention a donc été appliqué à ce bassin. La zone étudiée représente une surface de 500 000 km2 environ (500 km x 1000 km). Elle correspond aux couches sédimentaires de la base de la formation Montney, déposée au Trias sur une période de 2 millions d'années. Le bassin est discrétisé à l'aide de 5000 mailles.

Pour la couche considérée, on dispose de mesures de TOC et de IH en 7 puits dans le bassin (à comparer aux 50 x 100 soit 5000 mailles du modèle) et des cartes de bathymétrie (figure 3) et de vitesse de sédimentation (figure 4).

Sur la figure 3, les zones Z1 ont une bathymétrie comprise entre -75 et -50 m, la zone Z2 une bathymétrie entre - 50 et -25 m, la zone Z3 une bathymétrie entre - 25 et 0 m, la zone Z4 une bathymétrie entre 0 et 75 m, la zone Z5 entre 75 et 100 m, la zone Z6 entre 100 et 150 m, et la zone Z7 au-delà de 150 m.

Sur la figure 4, les zones A1 ont une vitesse de sédimentation comprise entre 0 et 8 m/Ma, la zone A2 entre 8 et 16 m/Ma, la zone A3 entre 16 et 32 m/Ma, la zone A4 entre 32 et 56 m/Ma, la zone A5 entre 56 et 64 m/Ma, la zone A6 entre 64 et 72 m/Ma.

Les résultats de mesures sur les échantillons de roche par Rock-Eval 6 [®] (IFP Energies nouvelles, France) sont reportés dans le tableau 1 ci-dessous avec la position des puits utilisés (les positions I et J représentent les numéros des mailles dans le domaine).

Tableau 1 - TOC et IH mesurés

| Position en I | Position en J | $TOC_A(P)$ | $IH_A(P)$ |
|---|---|---|---|
| 10 | 58 | 1.36 | 0 |
| 10 | 57 | 1.39 | 52 |
| 12 | 57 | 1.49 | 143 |
| 15 | 48 | 1.52 | 21 |
| 17 | 44 | 1.66 | 59 |
| 21 | 39 | 1.02 | 105 |
| 29 | 39 | 1.00 | 189 |
| 23 | 43 | 0.64 | 182 |

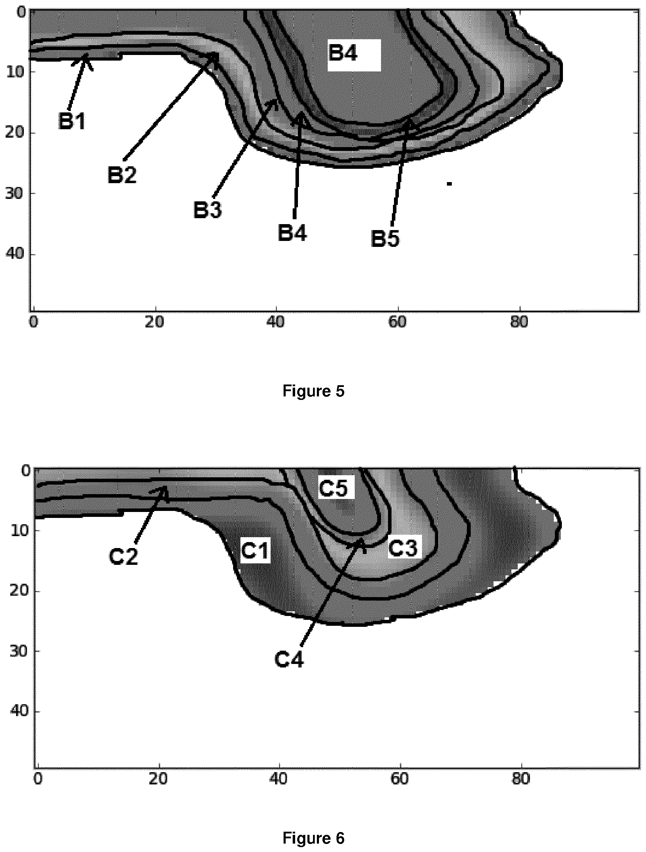

A partir de ces informations, au moyen du procédé selon l'invention, les valeurs des paramètres biologiques et chimiques sont déterminées par calage, puis appliquées à l'ensemble du bassin pour obtenir des cartes à l'échelle du bassin des valeurs de $TOC_0$ (figure 5) et de $IH_0$ (figure 6). Sur les figures 5 et 6, les zones blanches correspondent à une zone continentale, non lacustre ou marine. Par conséquent, en ces zones il n'est pas utile de déterminer les teneurs en carbone organique et l'indice d'hydrogène.

Sur la figure 5, la zone B1 a un TOC compris entre 0 et 1,2 %, la zone B2 un TOC entre 1,2 et 2 %, la zone B3 un TOC entre 2 et 2.4 %, la zone B4 un TOC entre 2.4 et 2.8 %, la zone B5 un TOC au-delà de 2.8 %.

Sur la figure 6, la zone C1 a un IH supérieur à 520, la zone C2 un IH entre 480 et 520, la zone C3 un IH entre 460 et 480, la zone C4 un IH entre 440 et 460, la zone C5 un IH inférieur à 440.

Pour cet exemple comparatif, on compare les valeurs de $TOC_0(P)$ déterminés au moyen du procédé selon l'invention, avec des valeurs de $TOC0(P)$ obtenues, sur la base d'une méthode de détermination du $TOC_0$, à partir des valeurs de IH, $IH_0$ et TOC actuelle, couramment admise (ex : Jarvie, 2012).

Pour la comparaison, on utilise la formule suivante de l'art antérieur :

$$TOC_0(P) = \frac{TOC_A(P)}{1 - \frac{IH_{0S}(P) - IH_A(P)}{1000} \times 0.84}$$

Tableau 2 - TOC simulés et calculés

| Position en I | Position en J | $TOC_0(P)$ selon l'invention | $TOC_0(P)$ selon l'art antérieur |
|---|---|---|---|
| 10 | 58 | 2.199239913 | 2.202300298 |
| 10 | 57 | 2.1640443 | 2.079777204 |
| 12 | 57 | 2.093971256 | 2.024799477 |
| 15 | 48 | 2.659069234 | 2.522195442 |
| 17 | 44 | 2.540686772 | 2.758488893 |
| 21 | 39 | 1.232681147 | 1.626519423 |
| 29 | 39 | 1.17093617 | 0.923460331 |
| 23 | 43 | 2.199239913 | 2.202300298 |

On observe donc que les valeurs de teneur organiques au temps du dépôt sont très similaires au niveau des puits. La construction de la carte de TOC selon l'invention est donc bien représentative du bassin sédimentaire au niveau des puits.

**Revendications**

1.  Procédé d'exploitation d'un bassin sédimentaire mis en oeuvre par ordinateur, ledit bassin sédimentaire comprenant au moins une couche sédimentaire, et étant traversé par au moins un puits, dans lequel on connaît la valeur de teneur en carbone organique $TOC_A(P)$ et la valeur de l'indice d'hydrogène $IH_A(P)$ au temps actuel au niveau d'au moins un puits, une carte de bathymétrie et une carte de vitesse de sédimentation de ladite couche sédimentaire, **caractérisé en ce qu'**on réalise les étapes suivantes :

    a) on construit pour au moins une couche sédimentaire des cartes de teneur en carbone organique $TOC_0$ et d'indice d'hydrogène $IH_0$ au temps du dépôt de ladite couche sédimentaire à partir desdites valeurs de teneur en carbone organique $TOC_A(P)$ et de l'indice d'hydrogène $IH_A(P)$ au temps actuel au niveau dudit puits, et au moyen desdites cartes de bathymétrie et de vitesse de sédimentation de ladite couche sédimentaire, au moyen des étapes suivantes :

    i) on construit des modèles de teneur en carbone organique $TOC_0$ et d'indice d'hydrogène $IH_0$ en tout point de ladite couche sédimentaire au temps du dépôt de ladite couche sédimentaire, lesdits modèles reliant ladite teneur en carbone organique $TOC_0$ et ledit indice d'hydrogène $IH_0$ en tout point de ladite couche sédimentaire au temps du dépôt de ladite couche sédimentaire, avec lesdites cartes de bathymétrie et de vitesse de sédimentation de ladite couche sédimentaire et avec des paramètres chimiques et biologiques de ladite couche sédimentaire ;

    ii) on cale lesdits modèles en déterminant lesdits paramètres chimiques et biologiques au moyen desdites valeurs actuelles de teneur en carbone organique $TOC_A(P)$ et la valeur de l'indice d'hydrogène $IH_A(P)$ au niveau dudit puits ; et

iii) on construit lesdites cartes de teneur en carbone organique $TOC_0$ et d'indice d'hydrogène $IH_0$ au temps du dépôt de ladite couche sédimentaire en appliquant lesdits modèles calés en toute maille de ladite couche sédimentaire au moyen des paramètres chimiques et biologiques déterminés et desdites cartes de vitesse de sédimentation et de bathymétrie ;

b) on détermine au moins une zone dudit bassin sédimentaire comportant des hydrocarbures au moyen desdites cartes de teneur en carbone organique $TOC_0$ et d'indice d'hydrogène $IH_0$ au temps du dépôt de ladite couche sédimentaire ; et
c) on exploite ladite zone dudit bassin sédimentaire, par la réalisation de forages d'exploration ou d'exploitation dans ladite au moins une zone déterminée.

2. Procédé selon la revendication 1, dans lequel on cale lesdits modèles en mettant en oeuvre les étapes suivantes :

(1) on choisit des paramètres biologiques et chimiques de ladite couche sédimentaire ;
(2) on détermine des valeurs de teneur en carbone organique $TOC_{0S}(P)$ et d'indice d'hydrogène $IH_{0S}(P)$ au niveau dudit puits au temps du dépôt de ladite couche sédimentaire au moyen desdits modèles, desdits paramètres biologiques et chimiques choisis et desdites cartes de bathymétrie et de vitesse de sédimentation ;
(3) on calcule une valeur de teneur en carbone organique $TOC_{0BC}(P)$ au niveau dudit puits au temps du dépôt de ladite couche sédimentaire au moyen d'un bilan carbone et desdites valeurs de teneur en carbone organique $TOC_A(P)$ et la valeur de l'indice d'hydrogène $IH_A(P)$ au temps actuel au niveau dudit puits ;
(4) on compare lesdites valeurs déterminées $TOC_{0S}(P)$ et calculées $TOC_{0BC}(P)$ de teneur en carbone organique au niveau dudit puits au temps de dépôt de ladite couche sédimentaire, et on réitère les étapes (2) à (4) en modifiant lesdits paramètres biologiques et chimiques pour minimiser ladite comparaison.

3. Procédé selon la revendication 2, dans lequel on calcule la valeur de teneur en carbone organique $TOC_{0BC}(P)$ au niveau dudit puits au temps du dépôt de ladite couche sédimentaire au moyen d'une formule du type: $TOC_{0BC}(P)$

$$= \frac{TOC_A(P)}{1 - \frac{IH_{0S}(P) - IH_A(P)}{1000} \times 0.84}$$

4. Procédé selon la revendication 2, dans lequel on calcule la valeur de teneur en carbone organique $TOC_{0BC}(P)$ au niveau dudit puits au temps du dépôt de ladite couche sédimentaire au moyen d'une formule du type: $TOC_{0BC}(P)$

$$= \frac{TOC_A(P) - 0.84 \times S1}{1 - \frac{IH_{0S}(P) - IH_A(P)}{1000} \times 0.84}$$ avec S1 la quantité d'huiles libres.

5. Procédé selon l'une des revendications 2 à 4, dans lequel ladite valeur de teneur en carbone organique $TOC_{0BC}(P)$ au niveau dudit puits au temps du dépôt de ladite couche sédimentaire est fonction d'un paramètre relatif à la formation de gaz biogénique au sein de ladite couche sédimentaire.

6. Procédé selon l'une des revendications précédentes, dans lequel lesdits paramètres biologiques et chimiques sont des paramètres représentatifs du dépôt de matière organique et/ou des réactions de réduction et/ou d'oxydation.

7. Procédé selon l'une des revendications précédentes, dans lequel lesdits modèles sont formés par interpolation desdites valeurs de teneur en carbone organique $TOC_0(P)$ et d'indice d'hydrogène $IH_0(P)$ au niveau dudit puits au temps du dépôt de ladite couche sédimentaire, l'interpolation étant contrainte par lesdites cartes de vitesse de sédimentation et de bathymétrie.

8. Procédé selon l'une des revendications précédentes, dans lequel lesdites valeurs de teneur en carbone organique $TOC_A(P)$ et de l'indice d'hydrogène $IH_A(P)$ au temps actuel au niveau dudit puits sont déterminées par analyse d'une pyrolyse d'une roche de ladite couche sédimentaire.

9. Procédé selon l'une des revendications précédentes, dans lequel on détermine au moins une zone dudit bassin sédimentaire comportant des hydrocarbures au moyen d'un modèle dudit bassin sédimentaire construit au moyen desdites cartes de teneur en carbone organique $TOC_0$ et d'indice d'hydrogène $IH_0$ au temps du dépôt de ladite couche sédimentaire.

10. Produit programme d'ordinateur téléchargeable depuis un réseau de communication et/ou enregistré sur un support lisible par ordinateur et/ou exécutable par un processeur, comprenant des instructions de code de programme pour la mise en oeuvre du procédé selon l'une des revendications précédentes, lorsque ledit programme est exécuté sur un ordinateur.

**Patentansprüche**

1. Von einem Computer ausgeführtes Verfahren zur Ausbeutung eines Sedimentbeckens, wobei das Sedimentbecken mindestens eine Sedimentschicht umfasst und von mindestens einem Bohrloch durchquert wird, wobei der Wert des Gehalts an organischem Kohlenstoff $TOC_A(P)$ und der Wert des Wasserstoffindex $IH_A(P)$ zum gegenwärtigen Zeitpunkt an mindestens einem Bohrloch, eine bathymetrische Karte und eine Karte der Sedimentationsgeschwindigkeit der Sedimentschicht bekannt sind, **dadurch gekennzeichnet, dass** die folgenden Schritte ausgeführt werden:

   a) Es werden für mindestens eine Sedimentschicht Karten des Gehalts an organischem Kohlenstoff $TOC_0$ und des Wasserstoffindex $IH_0$ zum Zeitpunkt der Ablagerung der Sedimentschicht aus den Werten des Gehalts an organischem Kohlenstoff $TOC_A(P)$ und des Wasserstoffindex $IH_A(P)$ zum gegenwärtigen Zeitpunkt an dem Bohrloch und mittels der bathymetrischen Karte und der Karte der Sedimentationsgeschwindigkeit der Sedimentschicht erstellt, mittels der folgenden Schritte:

      i) Es werden Modelle des Gehalts an organischem Kohlenstoff $TOC_0$ und des Wasserstoffindex $IH_0$ in jedem Punkt der Sedimentschicht zum Zeitpunkt der Ablagerung der Sedimentschicht erstellt, wobei diese Modelle den Gehalt an organischem Kohlenstoff $TOC_0$ und den Wasserstoffindex $IH_0$ in jedem Punkt der Sedimentschicht zum Zeitpunkt der Ablagerung der Sedimentschicht mit der bathymetrischen Karte und der Karte der Sedimentationsgeschwindigkeit der Sedimentschicht und mit chemischen und biologischen Parametern der Sedimentschicht verknüpfen;
      ii) die Modelle werden kalibriert, indem die chemischen und biologischen Parameter mittels der aktuellen Werte des Gehalts an organischem Kohlenstoff $TOC_A(P)$ und des Wertes des Wasserstoffindex $IH_A(P)$ an dem Bohrloch bestimmt werden; und
      iii) die Karten des Gehalts an organischem Kohlenstoff $TOC_0$ und des Wasserstoffindex $IH_0$ zum Zeitpunkt der Ablagerung der Sedimentschicht werden erstellt, indem die kalibrierten Modelle in jeder Masche der Sedimentschicht mittels der bestimmten chemischen und biologischen Parameter sowie der Karte der Sedimentationsgeschwindigkeit und der bathymetrischen Karte angewendet werden;

   b) es wird mindestens ein Bereich des Sedimentbeckens, der Kohlenwasserstoffe aufweist, mittels der Karten des Gehalts an organischem Kohlenstoff $TOC_0$ und des Wasserstoffindex $IH_0$ zum Zeitpunkt der Ablagerung der Sedimentschicht bestimmt; und
   c) der Bereich des Sedimentbeckens wird durch die Durchführung von Erkundungs- oder Produktionsbohrungen in dem mindestens einen bestimmten Bereich ausgebeutet.

2. Verfahren nach Anspruch 1, wobei die Modelle kalibriert werden, indem die folgenden Schritte durchgeführt werden:

   (1) es werden biologische und chemische Parameter der Sedimentschicht gewählt;
   (2) es werden Werte des Gehalts an organischem Kohlenstoff $TOC_{0S}(P)$ und des Wasserstoffindex $IH_{0S}(P)$ an dem Bohrloch zum Zeitpunkt der Ablagerung der Sedimentschicht mittels der Modelle, der gewählten biologischen und chemischen Parameter sowie der bathymetrischen Karte und der Karte der Sedimentationsgeschwindigkeit bestimmt;
   (3) es wird ein Wert des Gehalts an organischem Kohlenstoff $TOC_{0BC}(P)$ an dem Bohrloch zum Zeitpunkt der Ablagerung der Sedimentschicht mittels einer Kohlenstoffbilanz und der Werte des Gehalts an organischem Kohlenstoff $TOC_A(P)$ und des Wertes des Wasserstoffindex $IH_A(P)$ zum gegenwärtigen Zeitpunkt an dem Bohrloch berechnet;
   (4) die bestimmten $TOC_{0S}(P)$ und berechneten Werte $TOC_{0BC}(P)$ des Gehalts an organischem Kohlenstoff an dem Bohrloch zum Zeitpunkt der Ablagerung der Sedimentschicht werden verglichen, und die Schritte (2) bis (4) werden wiederholt, wobei die biologischen und chemischen Parameter geändert werden, um den Vergleich zu minimieren.

**3.** Verfahren nach Anspruch 2, wobei der Wert des Gehalts an organischem Kohlenstoff $TOC_{0BC}(P)$ an dem Bohrloch zum Zeitpunkt der Ablagerung der Sedimentschicht mittels einer Formel vom Typ

$$TOC_{0BC}(P) = \frac{TOC_A(P)}{1 - \dfrac{IH_{0S}(P) - IH_A(P)}{1000} \times 0{,}84}$$

berechnet wird.

**4.** Verfahren nach Anspruch 2, wobei der Wert des Gehalts an organischem Kohlenstoff $TOC_{0BC}(P)$ an dem Bohrloch zum Zeitpunkt der Ablagerung der Sedimentschicht mittels einer Formel vom Typ

$$TOC_{0BC}(P) = \frac{TOC_A(P) - 0{,}84 \times S1}{1 - \dfrac{IH_{0S}(P) - IH_A(P)}{1000} \times 0{,}84}$$

berechnet wird, wobei S1 die Menge an freien Ölen ist.

**5.** Verfahren nach einem der Ansprüche 2 bis 4, wobei der Wert des Gehalts an organischem Kohlenstoff $TOC_{0BC}(P)$ an dem Bohrloch zum Zeitpunkt der Ablagerung der Sedimentschicht von einem Parameter abhängig ist, der sich auf die Bildung von biogenem Gas innerhalb der Sedimentschicht bezieht.

**6.** Verfahren nach einem der vorhergehenden Ansprüche, wobei die biologischen und chemischen Parameter Parameter sind, die für die Ablagerung von organischem Material und/oder die Reduktions- und/oder Oxidationsreaktionen repräsentativ sind.

**7.** Verfahren nach einem der vorhergehenden Ansprüche, wobei die Modelle durch Interpolation der Werte des Gehalts an organischem Kohlenstoff $TOC_0(P)$ und des Wasserstoffindex $IH_0(P)$ an dem Bohrloch zum Zeitpunkt der Ablagerung der Sedimentschicht gebildet werden, wobei die Interpolation durch die Karte der Sedimentationsgeschwindigkeit und die bathymetrische Karte eingeschränkt wird.

**8.** Verfahren nach einem der vorhergehenden Ansprüche, wobei die Werte des Gehalts an organischem Kohlenstoff $TOC_A(P)$ und des Wasserstoffindex $IH_A(P)$ zum gegenwärtigen Zeitpunkt an dem Bohrloch durch Analyse einer Pyrolyse eines Gesteins der Sedimentschicht bestimmt werden.

**9.** Verfahren nach einem der vorhergehenden Ansprüche, wobei mindestens ein Bereich des Sedimentbeckens, der Kohlenwasserstoffe aufweist, mittels eines Modells des Sedimentbeckens bestimmt wird, das mittels der Karten des Gehalts an organischem Kohlenstoff $TOC_0$ und des Wasserstoffindex $IH_0$ zum Zeitpunkt der Ablagerung der Sedimentschicht erstellt wurde.

**10.** Computerprogrammprodukt, das aus einem Kommunikationsnetz herunterladbar und/oder auf einem computerlesbaren Datenträger aufgezeichnet und/oder durch einen Prozessor ausführbar ist und Programmcodeanweisungen zur Durchführung des Verfahrens nach einem der vorhergehenden Ansprüche, wenn das Programm auf einem Computer ausgeführt wird, umfasst.

**Claims**

**1.** Method for the exploitation of a sedimentary basin carried out by computer, said sedimentary basin comprising at least one sedimentary layer and having at least one well passing through it, in which the following are known: the value of content of organic carbon $TOC_A(P)$ and the value of the hydrogen index $IH_A(P)$ at the current time at at least one well, a map of bathymetry and a map of rate of sedimentation of said sedimentary layer, **characterized in that** the following stages are carried out:

a) for at least one sedimentary layer, maps of content of organic carbon $TOC_0$ and of hydrogen index $IH_0$ at the time of the deposition of said sedimentary layer are constructed starting from said values of content of organic carbon $TOC_A(P)$ and of hydrogen index $IH_A(P)$ at the current time at said well, and by means of said maps of bathymetry and of rate of sedimentation of said sedimentary layer, by means of the following stages:

    i) models of content or organic carbon $TOC_0$ and of hydrogen index $IH_0$ at any point of said sedimentary layer at the time of the deposition of said sedimentary layer are constructed, said models connecting said content of organic carbon $TOC_0$ and said hydrogen index $IH_0$ at any point of said sedimentary layer at the time of the deposition of said sedimentary layer with said maps of bathymetry and of rate of sedimentation of said sedimentary layer and with chemical and biological parameters of said sedimentary layer;

    ii) said models are adjusted by determining said chemical and biological parameters by means of said current values of content of organic carbon $TOC_A(P)$ and the value of the hydrogen index $IH_A(P)$ at said well; and

    iii) said maps of content of organic carbon $TOC_0$ and of hydrogen index $IH_0$ at the time of the deposition of said sedimentary layer are constructed by applying said adjusted models in every grid cell of said sedimentary layer by means of the chemical and biological parameters determined and said maps of rate of sedimentation and of bathymetry;

b) at least one zone of said sedimentary basin comprising hydrocarbons is determined by means of said maps of content of organic carbon $TOC_0$ and of hydrogen index $IH_0$ at the time of the deposition of said sedimentary layer; and

c) said zone of said sedimentary basin is exploited by carrying out exploratory or exploitation drillings in said at least one determined zone.

2. The method according to Claim 1, in which said models are adjusted by carrying out the following stages:

    (1) biological and chemical parameters of said sedimentary layer are chosen;

    (2) values of content of organic carbon $TOC_{0S}(P)$ and of hydrogen index $IH_{0S}(P)$ at said well at the time of the deposition of said sedimentary layer are determined by means of said models, of said chosen biological and chemical parameters and of said maps of bathymetry and of rate of sedimentation;

    (3) a value of content of organic carbon $TOC_{0BC}(P)$ at said well at the time of the deposition of said sedimentary layer is calculated by means of a carbon balance and of said values of content of organic carbon $TOC_A(P)$ and the value of the hydrogen index $IH_A(P)$ at the current time at said well;

    (4) said determined values $TOC_{0S}(P)$ and calculated values $TOC_{0BC}(P)$ of content of organic carbon at said well at the time of the deposition of said sedimentary layer are compared and stages (2) to (4) are repeated, modifying said biological and chemical parameters in order to minimize said comparison.

3. Method according to Claim 2, in which the value of content of organic carbon $TOC_{0BC}(P)$ at said well at the time of the deposition of said sedimentary layer is calculated by means of a formula of the type:

$$TOC_{0BC}(P) = \frac{TOC_A(P)}{1-\frac{IH_{0S}(P)-IH_A(P)}{1000}\times 0.84}.$$

4. Method according to Claim 2, in which the value of content of organic carbon $TOC_{0BC}(P)$ at said well at the time of the deposition of said sedimentary layer is calculated by means of a formula of the type:

$$TOC_{0BC}(P) = \frac{TOC_A(P)}{1-\frac{IH_{0S}(P)-IH_A(P)}{1000}\times 0.84}.$$

with S1 the amount of free oils.

5. Method according to one of Claims 2 to 4, in which said value of content of organic carbon $TOC_{0BC}(P)$ at said well at the time of the deposition of said sedimentary layer is a function of a parameter relating to the formation of biogenic gas within said sedimentary layer.

6. Method according to one of the preceding claims, in which said biological and chemical parameters are parameters representative of the deposition of organic matter and/or of the reduction and/or oxidation reactions.

7. Method according to one of the preceding claims, in which said models are formed by interpolation of said values of content of organic carbon $TOC_0(P)$ and of hydrogen index $IH_0(P)$ at said well at the time of the deposition of said sedimentary layer, the interpolation being constrained by said maps of rate of sedimentation and of bathymetry.

8. Method according to one of the preceding claims, in which said values of content of organic carbon $TOC_A(P)$ and of the hydrogen index $IH_A(P)$ at the current time at said well are determined by analysis of pyrolysis of a rock of said sedimentary layer.

9. Method according to one of the preceding claims, in which at least one zone of said sedimentary basin comprising hydrocarbons is determined by means of a model of said sedimentary basin constructed by means of said maps of content of organic carbon $TOC_0$ and of hydrogen index $IH_0$ at the time of the deposition of said sedimentary layer.

10. Computer program product which is downloadable from a communication network and/or recorded on a medium which is readable by a computer and/or executable by a processor, comprising program code instructions for the implementation of the method according to one of the preceding claims, when said program is executed on a computer.

TOC$_A$(P)
IH$_A$(P)
CB
CS

MOD

CAL

CAR

CON

ZI

EXP

**Figure 1**

PAR

SIM

BC

COMP

**Figure 2**

Figure 3

Figure 4

Figure 5

Figure 6

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2743738 A1, A. Lothe
- US 2015081265 A1
- FR 2930350
- US 8150669 B
- WO 2014040622 A1
- FR 2888251
- US 8753867 B
- FR 2722296
- US 5843787 A

**Littérature non-brevet citée dans la description**

- **STECKLER, M.S. ; A.B. WATTS.** Subsidence of the Atlantic-type continental margin off New York. *Earth Planet. Sci. Lett.,* 1978, vol. 41, 1-13
- **SYLTA.** Modeling techniques for hydrocarbon migration. *EAGE 64th Conférence and Exhibition, Florence,* 2002
- Transport of secondary oil migration using gradient-driven invasion percolation techniques. **CARRUTHERS.** PhD thesis. Heriot-Watt University, 1998
- **SCHNEIDER.** Modelling multi-phase flow of petroleum at the sedimentary basin scale. *Journal of Geochemical exploration,* 2003, vol. 78-79, 693-696